# EUROPEAN PATENT APPLICATION

(11) **EP 4 557 351 A1**
(43) Date of publication of application: **21.05.2025**
(21) Application number: 23925612.6
(22) Date of filing: 08.03.2023
(51) Int. Cl.: H01L 21/368, H01L 21/208

(54) **COATING APPARATUS AND COATING METHOD**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: SHIDA, Naomi, Tokyo 105-0023 (JP); NAITO, Katsuyuki, Kawasaki-shi, Kanagawa 210-0024 (JP); HIRAOKA, Toshiro, Tokyo 105-0023 (JP); TOBARI, Tomohiro, Kawasaki-shi, Kanagawa 212-0013 (JP)
(74) Representative: Marks & Clerk LLP
(86) International application number: PCT/JP2023/008874
(87) International publication number: WO 2024/185086

(57) **Abstract**

According to an embodiment, there are provided a coating device and a coating method for forming a coating film by a meniscus method, the coating device and the coating method being capable of forming a uniform coating film. The coating device includes:
a coating bar;
a base material conveyance member that conveys a base material;
a plurality of nozzles that supply the coating liquid to a surface of the coating bar; and
a coating liquid supply member that supplies the coating liquid to the nozzles,
in which a coating liquid supply amount adjustment member that adjusts a supply amount of the coating liquid to be supplied to the nozzles is provided at a position upstream of each of the nozzles.

## Description

### TECHNICAL FIELD

Embodiments of the present invention relate to a coating device and a coating method that can be used for device formation.

### BACKGROUND ART

Organic thin-film solar cells using an organic semiconductor and organic/inorganic hybrid solar cells are expected as low-cost solar cells because an inexpensive coating method can be applied to form an active layer. In order to implement the organic thin-film solar cell and the organic/inorganic hybrid solar cell at low cost, it is required to uniformly apply a coating material for forming an organic active layer and other layers. The thickness of each layer is about several nm to several 100 nm, and it is required to form such a very thin layer with a large area and high uniformity. For example, a meniscus coating method is known as one of roll-to-roll (R2R) coating methods capable of forming an extremely thin layer over a large area at low cost. As the meniscus coating method, a method of supplying a liquid to a coating bar head from a plurality of nozzles to obtain a single large-area coating film is simple, and a structure of an instrument is also simple. However, it may be difficult to obtain a uniform thickness, and a coating device capable of forming a more uniform coating film is desired.

### CITATION LIST

### PATENT LITERATURE

Patent Literature 1: JP 2006-167532 A

### SUMMARY OF THE INVENTION

### OBJECT OF THE INVENTION

Embodiments of the present invention provide a coating device and a coating method that are capable of forming a uniform coating film by a meniscus coating method and enable simple maintenance at the same time.

### SOLUTION TO PROBLEM

Embodiments provided by the present invention are as follows:
[1] A coating device for supplying a coating liquid to a surface of a base material to form a coating film by a meniscus method, the coating device including:
   a coating bar;
   a base material conveyance member that conveys the base material;
   a plurality of nozzles that supply the coating liquid to a surface of the coating bar; and
   a coating liquid supply member that supplies the coating liquid to the nozzles,
   in which a coating liquid supply amount adjustment member that adjusts a supply amount of the coating liquid to be supplied to the nozzles is provided at a position upstream of each of the nozzles.
[2] The coating device according to [1], further including a coating bar position adjustment member that controls a position of the coating bar.
[3] The coating device according to [1] or [2], further including a nozzle position detection member that detects contact between the coating bar and at least one of the nozzles.
[4] The coating device according to any one of [1] to [3], further including a nozzle position adjustment member that independently changes a distance between the plurality of nozzles and the coating bar.
[5] The coating device according to any one of [1] to [4], further including a coating liquid supply member that supplies the coating liquid to the nozzles, in which a total number of the coating liquid supply members is smaller than a total number of the nozzles.
[6] The coating device according to any one of [1] to [5], in which the coating bar is arranged so as not to rotate.
[7] The coating device according to any one of [1] to [6], in which the nozzle has a needle shape in which an opening surface of a coating liquid ejection port is cut to an angle of 75 degrees or more and 105 degrees or less.
[8] The coating device according to any one of [1] to [7], in which the nozzle is detachable.
[9] A coating method for forming a meniscus of a coating liquid between a coating bar and a base material, conveying the base material, and applying the coating liquid to a surface of the base material, the coating method including: supplying the coating liquid to a plurality of nozzles; supplying the coating liquid to the surface of the base material from the plurality of nozzles to a surface of the coating bar; and adjusting a supply amount of the coating liquid to be supplied to each of the plurality of nozzles upstream of each of the nozzles.
[10] The coating method according to [9], in which a total number of the coating liquid supply members is smaller than a total number of the nozzles.

### BRIEF DESCRIPTION OF DRAWINGS

[Fig. 1] Fig. 1 is a schematic side view illustrating a coating device according to a first embodiment.
[Fig. 2] Fig. 2 is a schematic top view illustrating the coating device according to the first embodiment.
[Fig. 3] Fig. 3 is a flowchart illustrating a coating method according to a second embodiment.

### BEST MODE FOR CARRYING OUT THE INVENTION

Hereinafter, embodiments of the present invention will be described in detail with reference to the drawings.

Note that the drawings are schematic or conceptual, and a relationship between a thickness and a width of each portion, a ratio between sizes of portions, and the like are not necessarily the same as actual ones. In addition, even in a case of representing the same portion, dimensions and ratios may be illustrated differently from each other depending on the drawings.

Note that, in the present specification and the respective drawings, elements similar to those described above in the previously described drawings are denoted by the same reference numerals, and the detailed description thereof is appropriately omitted.

### (First Embodiment)

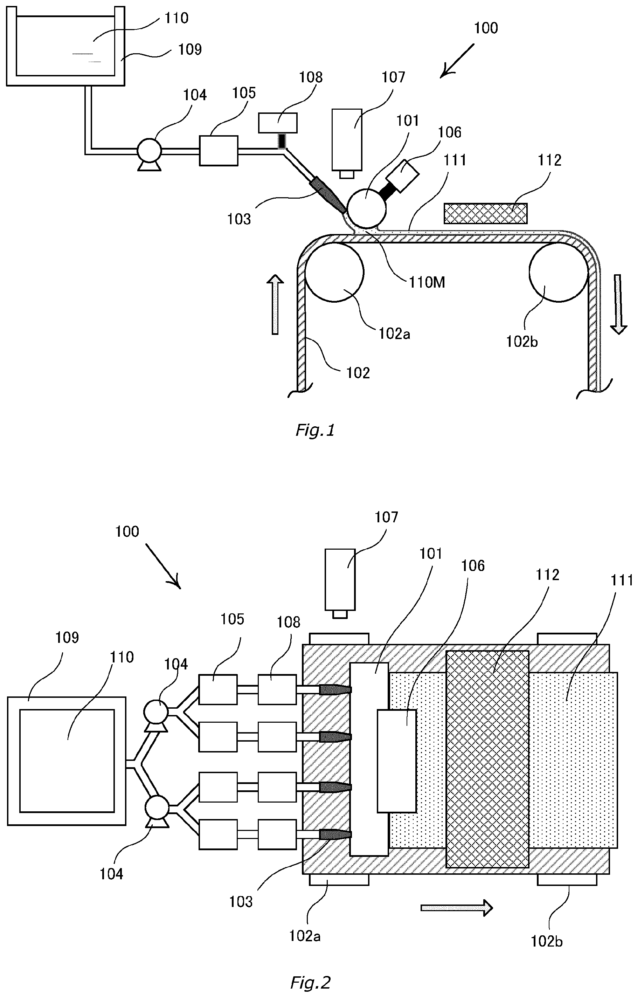

Fig. 1 is a schematic side view illustrating a coating device according to a first embodiment. Fig. 2 is a schematic top view illustrating the coating device according to the first embodiment.

As illustrated in Fig. 1, a coating device 100 according to the embodiment includes a nozzle position adjustment member 108, a coating bar 101, a mechanism 107 that detects a distance to nozzles 103, a coating liquid supply member 104 such as a liquid feeding pump that supplies a coating liquid 110 stored in a liquid reservoir or the like, and equipment material conveyance members such as conveyance rollers 102a and 102b that convey a base material 102. A coating liquid supply amount adjustment member 105 such as an adjustment valve is arranged upstream of each nozzle.

As illustrated in Fig. 2, in the coating device in the present embodiment, the number of nozzles 103 is plural. In addition, the number of coating liquid supply members such as the liquid feeding pumps 104 can also be plural. The total number of nozzles can be larger than the total number of liquid feeding pumps. In this case, a pipe from one pump to each nozzle is branched, and it is preferable that a coating liquid pipe is branched into two.

In the embodiment, as illustrated in Figs. 1 and 2, the coating liquid supply amount adjustment member 105 is installed at a position upstream of the nozzle 103.

The plurality of nozzles 103 can face the coating bar 101. As illustrated in Fig. 2, the plurality of nozzles 103 can supply the coating liquid 110 toward the coating bar 101.

As illustrated in Fig. 2, the plurality of nozzles 103 are arranged in a first direction. The first direction is, for example, a Y-axis direction. One direction perpendicular to the Y-axis direction is defined as an X-axis direction. The movement direction of the base material can coincide with an X axis. A direction perpendicular to the Y-axis direction and the X-axis direction is defined as a Z-axis direction. The coating bar 101 extends, for example, in the Y-axis direction.

As illustrated in Fig. 1, a meniscus 110M of the coating liquid 110 can be formed between the base material 102 and the coating bar 101. The meniscus 110M is in contact with the base material 102, and the base material 102 is moved in a movement direction (an arrow direction in the drawing), whereby the coating film 111 is formed on the base material 102. An intended film (solid film) is obtained by solidifying the coating film 111 by, for example, drying. The coating film 111 having a large area can be formed on the base material 102 by, for example, moving the base material 102 in the movement direction.

The coating bar applies the coating liquid 110 onto almost the entire surface of the base material 102, but in a case where a general coating method according to a related art is used, the thickness or the like may not be uniform. As a major cause of such a program, an ejection amount may vary between the nozzles 103. A liquid supply amount of each nozzle is roughly determined by the liquid feeding pump and varies depending on the number of pipes, a length of the pipe, a height of the pipe, a diameter of the pipe or nozzle, or a clogging state. The coating liquid supply amount adjustment member such as the liquid amount adjustment valve 105 can adjust the liquid supply amount, and it is possible to reduce the variation in the ejection amount of the coating liquid between the nozzles. In particular, in a case where the number of liquid feeding pumps is smaller than the number of nozzles, there is a tendency that the variation becomes small, which is preferable.

As the adjustment valve 105, a ball valve, a globe valve, a gate valve, a butterfly valve, a needle valve, a diaphragm valve, an electric valve, or the like can be used. A flow rate can also be adjusted by crushing a resin pipe with pressure.

The coating device according to the embodiment preferably further includes a coating bar position adjustment member 106 that controls an interval between the coating bar 101 and the base material 102. As this member, a gap ring, a micrometer, or the like can be used.

In the embodiment, the number of plurality of nozzles 103 may be three or more. As a result, the coating film 111 having a large area can be stably formed. In the example of Fig. 2, the number of plurality of nozzles 103 is four. In the embodiment, the number may be an arbitrary integer of 3 or more.

In the embodiment, the nozzle can be a slot die or can have a needle shape. For example, a discharge amount of the coating liquid 110 can be controlled with high accuracy by using the plurality of needle-shaped nozzles 103. When the nozzle has the needle shape, for example, tips of the nozzles are easily brought into contact with the coating bar 101 even in a case where the number of nozzles is considerably large. The needle-shaped nozzle has high flexibility. Due to the high flexibility, for example, damage to the nozzle due to vibration of the coating bar 101 or the like can be suppressed. In the needle-shaped nozzle, a length of the nozzle is, for example, 10 mm or more and 100 mm or less, and an inner diameter of the nozzle is, for example, 0.5 mm or more and 2 mm or less. An angle between an end surface of the tip of the nozzle and an extending direction of the nozzle is, for example, about 90 degrees (for example, 75 degrees or more and 105 degrees or less). With such a shape, for example, occurrence of scratches on the coating bar 101 can be suppressed.

Note that, in a case where a plurality of nozzles are arranged, a distance between the coating bar 101 and the tip of each nozzle tends to vary. When there is variation, the meniscus 110M formed from each nozzle is likely to be disturbed, and as a result, the coating film 111 is likely to be non-uniform.

In order to solve such a problem, if the nozzle position adjustment member 108 that adjusts the position of each nozzle and the nozzle position detection member 107 that detects the distance between the coating bar 101 and each nozzle 103 are provided as illustrated in Figs. 1 and 2, it is possible to reduce variation in the position and the distance between the tip of each nozzle and the coating bar, and to achieve uniform coating. Specifically, the position of each nozzle detected by the nozzle position detection member such as a camera is adjusted by the nozzle position adjustment member that physically adjusts the position of each nozzle.

In the embodiment, a member that detects contact between the coating bar and each nozzle can be further provided. The contact is easily detected by, for example, a method of measuring an electric resistance between the nozzle and the coating bar, and thus, the variation can be reduced by adjusting a coating condition based on the contact. When the nozzle and the coating bar are in contact with each other, the coating liquid can be directly applied to the coating bar, and repelling of the coating liquid hardly occurs.

In the embodiment, a member that measures the electric resistance between each nozzle and the coating bar can be provided as the member that detects the contact between the coating bar and each nozzle. If each nozzle and the coating bar are made of conductive stainless steel or the like, and the nozzles are insulated from each other, when the electric resistance between the coating bar and each nozzle is measured, the electric resistance is drastically reduced at a moment of contact. In addition, since the electric resistance changes as a contact state changes, the contact state can be monitored. For example, in a state in which the nozzle is pressed against the coating bar so strongly as to be greatly curved, the coating bar comes into contact with not only the tip of the nozzle but also a side surface of the nozzle, and the electric resistance becomes very low. In this case, the coating liquid is easily ejected from the tip of the nozzle to a portion other than the coating bar, and uneven coating is likely to occur. Since an optimum electric resistance varies depending on a shape and material of the nozzle and the coating bar, it is desirable to measure the optimum electric resistance in advance.

It is desirable to install a wiring connected to an electric resistance measuring instrument between the nozzles and the coating bar in advance. A switching portion is provided in the wiring, and each nozzle can be moved to confirm the contact with the coating bar before coating. If the electric resistance is also measured during the coating, it is possible to detect a case where there is an abnormality in the contact between the nozzle and the coating bar. The electric resistance measuring instrument can also be an external device separate from the coating device.

Note that, in the coating device according to the embodiment, the nozzle is preferably detachable. The nozzle is likely to be clogged due to a small opening. In the coating device according to the embodiment, when such clogging occurs, an ejection amount from each nozzle can be adjusted by the coating liquid supply member and a coating liquid supply amount adjustment member, but when clogging becomes severe or the ejection becomes completely impossible, it is necessary to perform cleaning or replacement. In such a case, it is preferable that the nozzle is detachable to facilitate maintenance.

The coating device 100 may further include a drying member 112. The drying member 112 can dry the coating liquid 111 applied to the base material 102. The drying member 112 may include, for example, an air nozzle or a far-infrared lamp.

In the embodiment, a cross-sectional shape of the coating bar 101 is arbitrary. The cross-sectional shape is, for example, a circular shape, a flat circular shape, or a polygonal shape. A portion of the cross-sectional shape that corresponds to a meniscus forming portion may be curved, and the other portion may be linear. For example, a cross-sectional shape of a surface of the coating bar 101 that faces the base material 102 may be curved.

The coating bar can be arranged so as not to rotate. As the coating bar does not rotate like a roller, stability of the meniscus is improved.

The coating bar 101 contains, for example, at least one selected from the group consisting of stainless steel, aluminum, titanium, and glass. Therefore, processing is facilitated when preparing the coating bar 101. In one example, the surface of the coating bar 101 is a mirror surface. In another example, the surface of the coating bar 101 may have an uneven structure.

### (Second Embodiment)

A second embodiment relates to a coating method. In the coating method according to the embodiment, for example, coating is performed using the coating device 100 (and a modification thereof) described in the first embodiment.

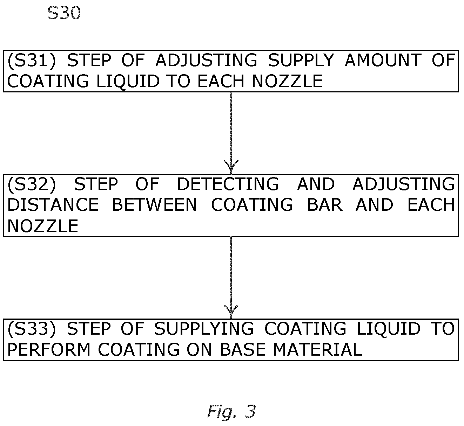

Fig. 3 is a flowchart illustrating the coating method (S30) according to the second embodiment.

The coating method according to the embodiment is a coating method in which a meniscus of a coating liquid is formed between a coating bar and a base material, the base material is conveyed, and the coating liquid is applied to a surface of the base material. Then, the coating liquid is supplied to a plurality of nozzles, and the coating liquid is supplied to the surface of the base material from the plurality of nozzles to a surface of the coating bar. At this time, a supply amount of the coating liquid to be supplied to each of the plurality of nozzles is adjusted upstream of each nozzle.

When performing such a method, prior to the supply of the coating liquid, first, the supply amount of the coating liquid to each nozzle is adjusted (S31)". The supply amount of the coating liquid can be adjusted by a coating liquid supply member such as a pump or a coating liquid supply amount adjustment member arranged upstream of the nozzle.

Next, a distance between the coating bar and each nozzle is detected, and the distance is adjusted as necessary (S32). The distance can be detected by a nozzle position detection member or the like. The distance can be adjusted by a coating bar position adjustment member or a nozzle position adjustment member.

Then, when the supply amount of the coating liquid is adjusted and the adjustment of the positions of the coating bar and the nozzles is completed, a step (S33) of supplying the coating liquid to perform coating on the base material can be performed.

Hereinafter, specific examples of the coating device and the coating method according to the embodiment will be described.

For example, a solar cell can be formed by coating with the coating device 100. In one example, the number of pumps is four. A pipe connected to one pump is connected to four nozzles. The total number of nozzles is 16. The nozzle is installed on one cantilever bar. An actuator for movement and a wiring for measuring the electric resistance are installed in each nozzle. The liquid amount adjustment valve is installed in each nozzle. The wiring is connected to the electric resistance measuring instrument. The nozzle position detection member such as a camera for observing a positional relationship between the nozzle and the coating bar is installed.

For example, the base material 102 is a roll-shaped PET film. A width of the PET film is, for example, 330 mm. A light-transmissive electrode having a width of 300 mm is formed on the PET film by a roll-to-roll sputtering device. A sheet resistance of the electrode is, for example, 10 Ω/□. The electrode has, for example, a laminated structure of ITO film/Ag alloy/ITO film. For example, a plurality of electrodes are provided. A length of one of the plurality of electrodes is, for example, about 10 mm. An interval between the plurality of electrodes is, for example, 50 µm.

The coating bar 101 has a circular cross-sectional shape. A radius of the circle is 10 mm. A length of the coating bar 101 is 300 mm. The coating bar 101 contains, for example, stainless steel (for example, SUS303).

The nozzle includes a stainless steel locking base. The length of the nozzle is 50 mm. A pipe for the coating liquid is a polytetrafluoroethylene tube. The liquid amount control valve is installed between the tube and the nozzle. The valve and the pipe are connected by a detachable joint. The pipe is connected to the pump.

In one example, a hole transport layer is formed by the coating liquid 110. In this case, the coating liquid 110 is an aqueous solution containing PEDOT and PSS.

For example, a gap ring or an actuator controls a relative positional relationship between the coating bar 101 and the base material 102.

For example, the nozzle is brought into a horizontal state. In such a state, the coating liquid 110 is supplied, and air in the nozzle is discharged. Thereafter, the pump and the liquid amount adjustment valve are adjusted to uniformly discharge the coating liquid from each nozzle.

Thereafter, the tip of the needle nozzle is lowered and inclined by, for example, 20° from the horizontal state. The cantilever is brought close to the coating bar. Next, each nozzle is brought close to and into contact with the coating bar one by one such that the electric resistance becomes 10 to 50 Ω.

The coating liquid 110 is continuously supplied by the pump while the base material 102 is conveyed. A movement speed of the base material 102 is, for example, 5 m/min. The drying member 112 blows heated dry air to the applied coating liquid 110. A solidified coating film is obtained from the coating liquid 110.

In the embodiment, another coating liquid may be further applied after the above coating. The another coating liquid contains, for example, a semiconductor material. The another coating liquid contains, for example, PTB7 ([poly{4,8-bis[(2-ethylhexyl)oxy]benzo[1,2-b:4,5-b']dithiophene-2,6-diyl-1t-alt-3-fluoro-2-[(2-ethylhexyl)carbonyl]thieno[3,4-b]thiophene-4,6-diyl}]) and PC70BM ([6,6]-phenyl-C71-butyric acid methylester). PTB7 is, for example, a p-type semiconductor. PC70BM is, for example, an n-type semiconductor. The another coating liquid further contains, for example, monochlorobenzene. An amount of PTB7 is 8 mg for 1 mL of monochlorobenzene. An amount of PC70BM is 12 mg for 1 mL of monochlorobenzene. The another coating liquid is a dispersion liquid containing an organic semiconductor.

The another coating liquid is, for example, a semiconductor film of a solar cell. When applying the another coating liquid, a minimum distance between the coating bar 101 and the base material 102 is 300 µm. A movement speed of the base material 102 is, for example, 5 m/min. After the coating, drying is performed by the drying member 112.

For example, there are an organic thin-film solar cell using an organic semiconductor and an organic/inorganic hybrid solar cell. By preparing such solar cells by the coating method, a high-performance solar cell can be prepared.

In the embodiment, the coating liquid 110 may be applied to the base material 102 at a position where the base material 102 is conveyed in a vertical direction. As a result, for example, an effect of gravity is applied to the meniscus, and a uniform film is easily obtained even at high speed.

According to the embodiments, the coating device and the coating method capable of forming a uniform coating film are provided.

The embodiments of the present invention have been described above with reference to specific examples. However, the present invention is not limited to the specific examples. For example, a specific configuration of each element such as the pipe, the pump, the nozzle, and a holding unit included in the coating device is included in the scope of the present invention as long as those skilled in the art can similarly carry out the present invention and obtain the same effect by appropriately selecting the configuration from known ranges.

In addition, a combination of any two or more elements of the respective specific examples within a technically possible range is also included in the scope of the present invention as long as the combination includes the gist of the present invention.

In addition, all the coating devices and coating methods that can be implemented by those skilled in the art by appropriately changing the design based on a coating head, the coating device, and the coating method described above as the embodiments of the present invention are also within the scope of the present invention as long as the coating devices and coating methods include the gist of the present invention.

In addition, those skilled in the art can conceive various changes and modifications within the scope of the idea of the present invention, and it is understood that the changes and modifications also fall within the scope of the present invention.

Although some embodiments of the present invention have been described, the embodiments have been presented as examples and are not intended to limit the scope of the invention. These novel embodiments can be implemented in various other forms, and various omissions, substitutions, and changes can be made without departing from the gist of the invention. The embodiments and modifications thereof are included in the scope and gist of the invention, and are included in the invention described in the claims and the equivalent scope thereof.

### REFERENCE SIGNS LIST

- 100: COATING DEVICE
- 101: COATING BAR
- 102: BASE MATERIAL
- 102a, 102b: CONVEYANCE MECHANISM
- 103: NOZZLE
- 104: PUMP
- 105: COATING LIQUID SUPPLY AMOUNT ADJUSTMENT MEMBER
- 106: COATING BAR POSITION ADJUSTMENT MEMBER
- 107: NOZZLE DISTANCE DETECTION MEMBER
- 108: NOZZLE POSITION ADJUSTMENT MEMBER
- 109: LIQUID RESERVOIR
- 110: COATING LIQUID
- 111: COATING FILM
- 112: DRYING MEMBER

## Claims

1. A coating device for supplying a coating liquid to a surface of a base material to form a coating film by a meniscus method, said coating device comprising:
a coating bar;
a base material conveyance member that conveys said base material;
a plurality of nozzles that supply said coating liquid to a surface of said coating bar; and
a coating liquid supply member that supplies said coating liquid to said nozzles,
wherein a coating liquid supply amount adjustment member that adjusts a supply amount of said coating liquid to be supplied to said nozzles is provided at a position upstream of each of said nozzles.

2. The coating device according to claim 1, further comprising a coating bar position adjustment member that controls a position of said coating bar.

3. The coating device according to claim 1 or 2, further comprising a nozzle position detection member that detects contact between said coating bar and at least one of said nozzles.

4. The coating device according to claim 1 or 2, further comprising a nozzle position adjustment member that independently changes a distance between the plurality of nozzles and said coating bar.

5. The coating device according to claim 1 or 2, further comprising a coating liquid supply member that supplies said coating liquid to said nozzles, wherein a total number of said coating liquid supply members is smaller than a total number of said nozzles.

6. The coating device according to claim 1 or 2, wherein said coating bar is arranged so as not to rotate.

7. The coating device according to claim 1 or 2, wherein said nozzle has a needle shape in which an opening surface of a coating liquid ejection port is cut to an angle of 75 degrees or more and 105 degrees or less.

8. The coating device according to claim 1 or 2, wherein said nozzle is detachable.

9. A coating method for forming a meniscus of a coating liquid between a coating bar and a base material, conveying said base material, and applying said coating liquid to a surface of said base material, said coating method comprising: supplying said coating liquid to a plurality of nozzles; supplying said coating liquid to the surface of said base material from the plurality of nozzles to a surface of said coating bar; and adjusting a supply amount of said coating liquid to be supplied to each of the plurality of nozzles upstream of each of said nozzles.

10. The coating method according to claim 9, wherein a total number of said coating liquid supply members is smaller than a total number of said nozzles.
